**Europäisches Patentamt**

(19) **European Patent Office**

**Office européen des brevets**

(11) Veröffentlichungsnummer: **0 065 173**
**B1**

(12) # EUROPÄISCHE PATENTSCHRIFT

(45) Veröffentlichungstag der Patentschrift:
**04.11.87**

(51) Int. Cl.⁴: **H 01 L 29/743,** H 01 L 29/74, H 01 L 29/52, H 01 L 29/08

(21) Anmeldenummer: **82103784.3**

(22) Anmeldetag: **03.05.82**

(54) **Thyristor mit verbessertem Schaltverhalten.**

(30) Priorität: **08.05.81 DE 3118305**

(43) Veröffentlichungstag der Anmeldung:
**24.11.82 Patentblatt 82/47**

(45) Bekanntmachung des Hinweises auf die Patenterteilung:
**04.11.87 Patentblatt 87/45**

(84) Benannte Vertragsstaaten:
**CH FR GB IT LI SE**

(56) Entgegenhaltungen:
**EP-A-0 006 008**
**EP-A-0 028 797**
**DE-A-1 211 334**
**DE-A-2 163 922**
**DE-A-2 625 917**

(73) Patentinhaber: **Siemens Aktiengesellschaft Berlin und München, Wittelsbacherplatz 2, D-8000 München 2 (DE)**

(72) Erfinder: **Stoisiek, Michael, Dr., Robert- Koch-Strasse 24, D-8012 Ottobrunn (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 065 173 B1

## Beschreibung

Die Erfindung bezieht sich auf einen Thyristor nach den gleichlautenden Oberbegriffen der Patentansprüche 1 oder 2.

Ein solcher Thyristor ist aus der DE-A-26 25 917 bekannt. Er weist als MIS-Strukturen ausgebildete, steuerbare Emitterkurzschlüsse auf, die zum Zwecke eines schnellen Löschens des Thyristors wirksam geschaltet werden. Andererseits können die steuerbaren Emitterkurzschlüsse auch während des Auftretens eines Zündimpulses wirksam geschaltet werden, um eine Zündung zu verhindern. Die steuerbaren Emitterkurzschlüsse sind hierbei wegen ihrer wesentlichen Funktion zweckmäßigerweise als Löschkurzschlüsse zu bezeichnen.

Aus der DE-A-12 11 334 ist ebenfalls ein Thyristor der vorstehend beschriebenen Art mit steuerbaren Emitterkurzschlüssen bekannt, die als Löschkurzschlüsse dienen.

Ein gemäß Artikel 54(3) EPÜ zum Stand der Technik gehörender Thyristor ist in der EP-A-00 28 797 beschrieben. Er besitzt einen Halbleiterkörper, der einen von einer Kathode kontaktierten n-Emitter mit einer angrenzenden p-Basisschicht und einen von einer Anode kontaktierten p-Emitter mit einer angrenzenden n-Basisschicht aufweist. Ferner besitzt er an einer Grenzfläche des Halbleiterkörpers angeordnete, als MIS-Strukturen ausgebildete, steuerbare Emitterkurzschlüsse. Diese bestehen jeweils aus einem ersten Halbleitergebiet eines ersten Leitungstyps, das mit der den kurzzuschließenden Emitter kontaktierenden Elektrode, d.h. Kathode oder Anode, elektrisch verbunden ist, ferner aus einem zweiten Halbleitergebiet des ersten Leitungstyps, das mit der an diesen Emitter angrenzenden Basisschicht elektrisch verbunden ist und aus einer zwischen diesen Halbleitergebieten liegenden Zwischenschicht eines zweiten Leitungstyps, die von einem gegenüber dem Halbleiterkörper elektrisch isolierten Gate überdeckt ist. Das erste Halbleitergebiet besteht hierbei jedoch nicht aus dem Randbereich des kurzzuschließenden Emitters. Weiterhin handelt es sich bei dem zweiten Halbleitergebiet auch nicht um ein in die Basisschicht eingefügtes Kurzschlußgebiet. Die Zwischenschicht des zweiten Leitungstyps wird im übrigen auch nicht von einem Teilbereich der an den kurzzuschließenden Emitter angrenzenden Basisschicht gebildet. Bei diesem Thyristor gehört wenigstens eine der MIS-Strukturen dem Verarmungstyp an und wenigstens eine andere der MIS-Strukturen dem Anreicherungstyp, wobei ein erster gemeinsamer Steueranschluß für die Gates der MIS-Strukturen des einen Typs und ein zweiter gemeinsamer Steueranschluß für die Gates der MIS-Strukturen des anderen Typs vorgesehen sind. Die MIS-Strukturen des einen Typs dienen dabei als Löschkurzschlüsse, die des anderen Typs als Stabilisierungskurzschlüsse, die im blockierten Zustand des Thyristors bzw. vor dem Zünden desselben wirksam geschaltet sind und lediglich während des Zündvorgangs unwirksam geschaltet werden.

Der vorliegenden Erfindung liegt die Aufgabe zugrunde, eine einfache und leicht herzustellende Ausführungsform eines Thyristors der eingangs genannten Art anzugeben, der mit wenigstens einem Stabilisierungskurzschluß und zusätzlich mit wenigstens einem Löschkurzschluß versehen ist. Das wird durch eine Ausbildung desselben nach dem kennzeichnenden Teil des Patentanspruchs 1 oder nach dem kennzeichnenden Teil des Patentanspruchs 2 erreicht.

Der hiermit erzielbare Vorteil besteht insbesondera darin, daß die Herstellung der für die steuerbaren Emitterkurzschlüsse erforderlichen Halbleitergebiete im Rahmen derjanigen Dotierungsschritte erfolgt, die bareits zur Herstellung der einzalnen Halbleitergebiete bzw. -schichten des Thyristors benötigt werden, so daß der Mehraufwand für die steuerbaren Emittarkurzschlüsse sehr klein gehalten werden kann.

Die Ansprüche 3 bis 5 betreffen Weiterbildungen des Thyristors nach der Erfindung, während die Ansprüche 6 und 7 auf Verfahren zum Betrieb eines erfindungsgemäßen Thyristors gerichtet sind.

Nachfolgend wird die Erfindung anhand der Zeichnung näher erläutert. Dabei zeigen:

Fig. 1 ein erstes Ausfürungsbeispiel der Erfindung,

Fig. 2a und Fig. 2b Spannungs-Zeit-Diagramme zur Erläuterung von Fig. 1,

Fig. 3a und Fig. 3b weitere Spannungs-Zeit-Diagramme zur Erläuterung von Fig. 1,

Fig. 4 eine Teilschaltung von Fig. 1,

Fig. 5 eine endere Teilschaltung von Fig. 1 und

Fig. 6 ein zweites Ausführungsbeispiel der Erfindung.

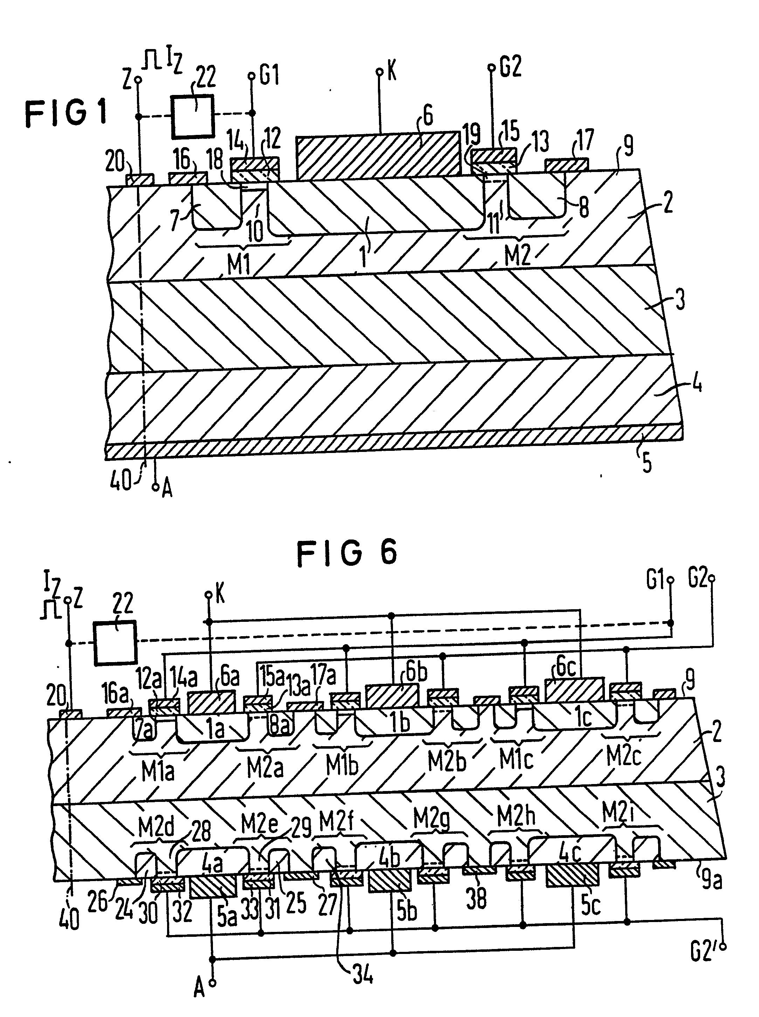

In Fig. 1 ist ein Thyristor mit einem aus dotiertem Halbleitermaterial, z. B. Silizium, bestehenden Halbleiterkörper dargestellt, der vier aufeinanderfolgende Schichten abwechselnder Leitungstypen aufweist. Dabei bezeichnet man eine n-leitende Schicht 1 als den n-Emitter, eine p-leitende Schicht 2 als die p-Basis, eine n-leitende Schicht 3 als die n-Basis und eine p-leitende Schicht 4 als den p-Emitter. Der p-Emitter 4 ist mit einer Anode 5 aus leitenden Material, z. B. Aluminium, versehen, die einen Anschluß A hat, während der n-Emitter 1 eine Kathode 6 aus leitendem Material, z. B. Aluminium, mit einem Anschluß K aufweist.

Randseitig zu dem n-Emitter 1 sind n-leitende Kurzschlußgebiete 7 und 8 derart in die p-Basisschicht 2 eingefügt, daß sie sich bis zur Grenzfläche 9 des Halbleiterkörpers erstrecken. Die Kurzschlußgebiete 7 und 8 können zweckmäßigerweise zusammen mit dem n-Emitter 1 in ein und demselben Dotierungsschritt hergestellt werden. Teilbereiche 10 und 11 der p-Basisschicht 2, die mit ihrer Breite den Abstand der Gebiete 7 und 8 von dem n-Emitter 1 bestimmen, sind von dünen elektrisch isolierenden Schichten 12 und 13 überdeckt, auf denen Gates 14 und 15 angeordnet sind. Diese bestehen aus elektrisch leitendem Material, z. B. Aluminium, und sind jeweils mit Steueranschlüssen G1 und G2 verbunden. Leitende Belegungen 16, 17 überbrücken die pn-Übergänge zwischen der p-Basisschicht 2 und den Kurzschlußgebieten 7 und 8 an den vom n-Emitter 1 abgewandten Rändern der letzteren. Der linke Randbereich des n-Emitters 1 stellt dabei ein erstes und das Kurzschlußgebiet 7 ein zweites n-leitendes Halbleitergebiet einer MIS-Struktur M1 dar, zu der auch der p-leitende Teilbereich 10, die isolierende Schicht 12 und das Gate 14 gehören. In analoger Weise wird aus dem rechten Randbereich von 1 zusammen mit den Teilen 8, 11, 13 und 15 eine MIS-Struktur M2 gebildet.

Die Struktur M1 ist als solche des Verarmungstyps ausgebildet, so daß bei spannungslosem Steueranschluß G1 ein n-leitender Kanal 18 an der Grenzfläche 9 unterhalb von 14 vorhanden ist, der die Gebiete 1 und 7 niederohmig miteinander verbindet. Dabei besteht der n-Kanal 18 entweder aus einem Inversionskanal, der durch ein an der Grenzfläche 9 bestehendes, den Teilbereich 10 beeinflussendes elektrisches Feld aufgebaut worden ist, oder aus einem dotierten Kanal, der durch eine flache n-Dotierung unmittelbar an der Grenzfläche 9 erzeugt worden ist. Führt man dem Steueranschluß G1 eine negative Spannung zu, so wird der n-Kanal 18 unterbrochen.

Im Gegensatz hierzu ist die Struktur M2 als eine solche des Anreicherungstyps ausgebildet, bei der in dem Teilbereich 11 ohne Zuführung einer Spannung an den Steueranschluß G2 kein Kanal ausgebildet ist. Erst bei Zuführung einer positiven Spannung an den Steueranschluß G2 entsteht ein mit 19 bezeichneter und in Fig. 1 gestrichelt dargestellter n-leitender Inversionskanal.

Die Struktur M1 bildet einen Halbleiterschalter, der in einem ersten Schaltzustand (spannungsloser Steueranschluß G1) den n-Emitter 1 mit dem Kurzschlußgebiet 7 und weiterhin über die leitende Belegung 16 auch mit der p-Basisschicht 2 niederohmig verbindet. In einem zweiten Schaltzustand (Zuführung einer negativen Spannung an G1) wird diese niederohmige Verbindung dann unterbrochen bzw. hochohmig geschaltet. Somit stellt die Struktur M1 einschließlich der Belegung 16 einen ersten steuerbaren Emitterkurzschluß des Thyristors dar. Andererseits bildet M2 einen Halbleiterschalter, der in einem ersten Schaltzustand (Zuführung einer positiven Spannung an G2) den n-Emitter 1 mit dem Kurzschlußgebiet 8 und weiterhin über die Belegung 17 auch mit der p-Emitterschicht niederohmig verbindet, während er in einem zweiten Schaltzustand (spannungsloser Steueranschluß G2) diese Verbindung unterbricht. M2 bildet damit einschließlich der Belegung 17 einen zweiten steuerbaren Emitterkurzschluß.

Auf der p-Basisschicht ist eine-Zündelektrode 20 vorgesehen, die mit dem Anschluß Z eines Zündstromkreises verbunden ist.

In Betrieb sind die Steueranschlüsse G1 und G2 nach Fig. 1 im blockierenden Zustand des Thyristors zunächst von Spannungen freigeschaltet. Dabei ist der n-Emitter 1 wegen des wirksam geschalteten n-Kanals 18 über die Struktur M1 niederohmig mit der p-Basisschicht 2 verbunden, während über M2 wegen des fehlenden n-Kanals 19 keine niederohmige Verbindung zwischen den Teilen 1 und 2 besteht. Der steuerbare Enitterkurzschluß M1, 16 ist also wirksam geschaltet und stabilisiert den Thyristor gegen unbeabsichtigte Zündvorgänge beim Anliegen von großen oder schnell ansteigenden Blockierspannungen zwischen den Anschlüssen A und K. Daher wird der Kurzschluß M1, 16 im folgenden als Stabilisierungskurzschluß bezeichnet.

Zur Zündung des Thyrristors wird dem Anschluß Z ein Zündstromimpuls $I_z$ zugeführt.

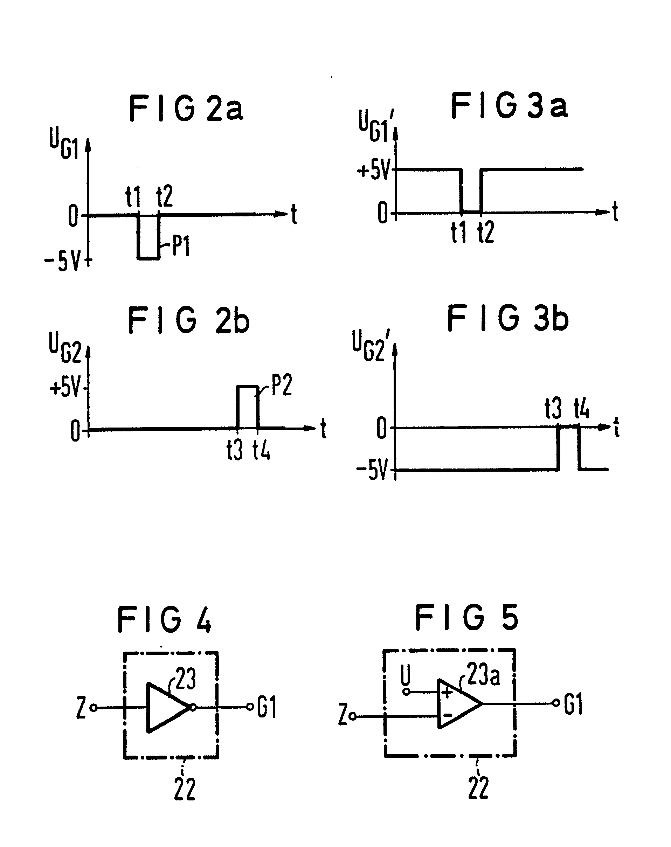

Gleichzeitig wird G1 für die Dauer des Zündvorgangs mit einem negativen Spannungsimpuls P1 beaufschlagt, der den n-Kanal 18 unterbricht und damit den Stabilisierungskurzschluß M1, 16 während des gesamten Zündvorgangs unwirksam schaltet. Fig. 2a zeigt den zeitlichen Verlauf der Spannung $U_{G1}$, die dem Steueranschluß G1 in Betrieb zugeführt wird. Wie hieraus hervorgeht, bleibt G1 spannungslos bis auf ein Zeitintervall t1 bis t2, in dem der Zündvorgang abläuft. In diesem Zeitintervall liegt ein Spannungsimpuls P1 von z. B. -5V an G1. Nach erfolgter Zündung fließt dann ein Laststrom eines bei A und K angeschlossenen Laststromkreises über den niederohmig geschalteten Thyristor.

Soll der Thyristor im Zeitpunkt t3 trotz einer in Durchlaßrichtung gepolten Spannung an A und K gelöscht werden, so wird der Emitterkurzschluß M2, 17 kurzzeitig von t3 bis t4 wirksam geschaltet. Fig. 2b zeigt die Zeitabhängigkeit einer Spannung $U_2$, die dem Steueranschluß G2 im Betrieb zugeführt wird. Wie hieraus hervorgeht, liegt nur im Zeitintervall t3 bis t4 ein Spannungsimpuls P2 von z. B. +5V an. Von t3 bis t4 sind dann beide Emitterkurzschlüsse M1, 16 und M2, 17 wirksam, so daß die im Durchlaßzustand des Thyristors die Basisschichten 2 und 3 überschwemmenden Defektelektronen über beide Kurzschlüsse zur Kathode 6 abgeleitet werden. Damit gelangt der Thyristor rasch wieder in den blockierenden Zustand. Da der Emitterkurzschluß M2, 17 lediglich zum Zwecke des Löschens des Thyristors wirksam geschaltet ist, wird er im folgenden als Löschkurzschluß bezeichnet.

Die MIS-Struktur M1 ist zweckmäßigerweise im einzelnen so ausgebildet, daß der über M1 gesteuerte Emitter-Kurzschlußpfad 16, 7, 18 in seinem niederohmigen Zustand einen Widerstandswert aufweist, der zwar klein genug ist, um im blockierenden Zustand auftretende Störströme zur Kathode abzuleiten, aber immer noch so groß ist, daß er in Durchlaßzustand, d. h. im stromführenden Zustand des Thyristors, nicht zum Löschen des Thyristors führt. Andererseits ist die MIS-Struktur M2 zweckmäßigerweise so ausgebildet, daß der über M2 gesteuerte Emitter-Kurzschlußpfad 17, 8, 19 in seinem niederohmigen Zustand einen sehr kleinen Widerstandswert aufweist, so daß ein sicheres Löschen des Thyristors erreicht wird.

Eine zweite Ausführungsform der Erfindung unterscheidet sich von Fig. 1 dadurch, daß die Struktur M1 ebenso wie M2 dem Anreicherungstyp angehört. Um die bereits beschriebene Wirkungsweise des Stabilisierungskurzschlusses M1, 17 unverändert aufrecht zu erhalten, ist es in diesem Falle notwendig, dem Steueranschluß G1 anstelle des Impulses P1 eine Spannung $U_{G1}'$ entsprechend Fig. 3a zuzuführen. Diese weist vor dem Zündzeitpunkt t1 einen Pegel von z. B. +5V auf, durch den die Bildung eines n-leitenden Inversionskanals 18 veranlaßt wird. Während des Zündvorgangs, der im Zeitintervall t1 bis t2 stattfindet, wird der Pegel auf 0V abgesenkt, so daß der n-Kanal 18 für diesen Zeitraum aufgehoben wird.

Bei einer weiteren Ausführungsform der Erfindung ist die Struktur M2 in Abweichung in Fig. 1 ebenso wie M1 als eine solche des Verarmungstyps ausgebildet. Dabei ist bei spannungslosem Anschluß G2 ein n-Kanal 19 vorhanden, der entweder aus einem durch ein elektrisches Oberflächenfeld erzeugten Inversionskanal oder aus einem dotierten n-Kanal besteht, welcher durch eine flache n-Diffusion im Halbleiterbereich 11 an der Grenzfläche 9 des Halbleiterkörpers erzeugt ist. Die bereits beschriebene Wirkungsweise des Löschkurzschlusses M2, 17 wird in diesem Fall bei einer Ansteuerung von G2 mit einer Steuerspannung $U_{G2}'$ gemäß Fig. 3b erreicht. Diese weist außerhalb des Zeitintervalls t3 bis t4 einen Pegel von z. B. -5V auf, durch den der Kanal 19 aufgehoben bzw. hochohmig geschaltet wird, während innerhalb dieses Zeitintervalls der Pegel auf 0V angehoben wird so daß der Löschkurzschluß M2, 17 von t3 bis t4 wirksam geschaltet ist.

Eine Zusatzschaltung 22, die eingangsseitig mit Z und ausgangsseitig mit G1 verbunden ist, wird mit Vorteil dazu verwendet, um von der positiven Zündspannung, die beim Einspeisen von $I_z$ am Anschluß Z entsteht, die am Anschluß G1 benötigte Spannung abzuleiten. Wird für G1 ein Impuls P1 (Fig. 2a) benötigt, so besteht die Zusatzschaltung 22 gemäß Fig. 4 aus einer Polaritätsumkehrschaltung, z. B. einem invertierenden Verstärker 23. Zur Ableitung einer Spannung $U_{G1}'$ besteht die Zusatzschaltung 22 aus einer Polaritätsumkehrschaltung mit Pegelverschiebung. Hierzu wird mit Vorteil ein Differenzverstärker 23a (Fig. 5) verwendet, dessen positiver Eingang mit einer Spannung +U beschaltet ist, die der Amplitude der an Z auftretenden Zündspannung entspricht, während sein negativer Eingang mit Z und sein Ausgang mit G1 beschaltet sind.

Fig. 6 zeigt ein Ausführungsbeispiel der Erfindung, bei dem an der Grenzfläche 9 des Halbleiterkörpers drei n-Emittergebiete 1a, 1b und 1c vorgesehen sind, die jeweils von Teilen 6a, 6b und 6c der Kathode kontaktiert werden. Die Teile 6a bis 6c sind an einen gemeinsamen Anschluß K geführt. Randseitig zu dem Emittergebiet 1a sind MIS-Strukturen M1a und M2a vorgesehen, die den Strukturen M1 und M2 von Fig. 1 nach Aufbau und Wirkungsweise entsprechen. Die Bezeichnungen einander entsprechender Schaltungsteile in den Figuren 1 und 6 unterscheiden sich lediglich dadurch, daß die Bezeichnungen in Fig. 6 jeweils durch den Buchstaben a ergänzt sind.

Randseitig zu dem n-Emittergebiet 1b sind in Fig. 6 zwei weitere MIS-Strukturen M1b und M2b vorgesehen, die den Strukturen M1 und M2 von Fig. 1 ebenfalls nach Aufbau und Wirkungsweise entsprechen. Das gleiche gilt für die Strukturen M1c und M2c, die randseitig zu dem n-Emittergebiet 1c angeordnet sind.

Wie aus Fig. 6 ersichtlich ist, sind die Gates der Strukturen M1a, M1b und M1c mit einem gemeinsamen Steueranschluß G1 verbunden, so daß M1a, M1b und M1c mit einem gemeinsamen Steueranschluß G1 verbunden, so daß M1a, M1b und M1c jeweils Teile von Stabilisierungskurzschlüssen darstellen. In gleicher Weise sind die Gates von M2a, M2b und M2c mit einem gemeinsamen Steueranschluß G2 verbunden, so daß M2a, M2b und M2c jeweils Teile von Löschkurzschlüssen bilden. Vervollständigt werden die Stabilisierungskurzschlüsse durch die jeweils links von den n-Emittergebieten vorgesehenen, leitenden Belegungen, z. B. 16a, und die Löschkurzschlüsse durch die jeweils rechts von den n-Emittergebieten angeordneten leitenden Belegungen z. B. 17a.

Wie Fig. 6 weiterhin zeigt, kann der p-Emitter 4 des Thyristors in eine Mehrzahl von p-Emittergebieten 4a, 4b und 4c aufgeteilt sein, die jeweils mit untereinander verbundenen Teilen 5a, 5b und 5c der Anode versehen sind. Randseitig zu dem p-Emittergebiet 4a sind p-leitende Kurzschlußgebiete 24 und 25 in die n-Basisschicht 3 eingefügt, die sich bis zur Grenzfläche 9a des Halbleiterkörpers erstrecken. An den von dem Gebiet 4a abgewandten Rändern der Kurzschlußgebiete 24 und 25 sind jeweils leitende Belegungen 26 und 27 vorgesehen, die die pn-Übergänge zwischen den Gebieten 24 bzw. 25 und der n-Basisschicht 3 überbrücken. p-leitende Halbleiterbereiche 28 und 29, die mit ihrer Breite die Abstände der Kurzschlußgebiete 24 und 25 vom p-Emittergebiet 4a bestimmen, sind von dünnen, elektrisch isolierenden Schichten 30 und 31 überdeckt, auf denen Gates 32 und 33 angeordnet sind. Diese bestehen aus elektrisch leitendem Material, z. B. Aluminium, und sind an einen gemeinsamen Anschluß G2' geführt. Es ergeben sich auf diese Weise zwei MIS-Strukturen M2d und M2e randseitig zu dem p-Emittergebiet 4a, zwei MIS-Strukturen M2f und M2g randseitig zu 4b und zwei MIS-Strukturen M2h und M2i randseitig zu 4c.

Die Strukturen M2d bis M2i entsprechen jeweils der Struktur M2 von Fig. 1 nach Aufbau und Wirkungsweise, wobei ihren an einen gemeinsamen Steueranschluß G2' geschalteten Gates die gleichen Spannungen wie dem Steueranschluß G2, jedoch mit entgegengesetzter Polarität zugeführt werden. Die leitenden Belegungen, z. B. 27, sind dabei jeweils so großflächig ausgeführt, daß sie die pn-Übergänge von zwei nebeneinanderliegenden Kurzschlußgebieten, z. B. 25 und 34, gegenüber der n-Basisschicht 3 gemeinsam überbrücken. Die übrigen Schaltungsteile von Fig. 6 entsprechen den mit gleichen Bezugszeichen versehenen von Fig. 1. M2d bis M2i stellen jeweils Teile von Löschkurzschlüssen dar und werden durch die leitenden Belegungen, z. B. 26 und 27, zu solchen ergänzt.

Ein nach Fig. 6 ausgebildeter Thyristor wird durch Zuführung eines Spannungsimpulses P1 oder einer Spannung $U_{G1}'$ an den Steueranschluß G1 sehr zündempfindlich gemacht, was bei Zuführung eines Zündstromimpulses $I_z$ an Z zu einem schnellen Zündvorgang führt. Andererseits wird der im stromführenden Zustand befindliche Thyristor durch Zuführung von P2 bzw. $U_{G2}'$ an den Steueranschluß G2 sowie von einer der beiden letztgenannten Spannungen mit umgekehrter Polung an G2' sehr schnell wieder gelöscht.

Bei dem in Fig. 6 dargestellten Thyristor können die MIS-Strukturen M2d bis M2i auch entfallen, wobei dann der p-Emitter entsprechend Fig. 1 als ungeteilte Schicht ausgebildet ist, die mit einer ungeteilten Anode 5 belegt ist.

In den Figuren 1 und 6 kann die strichpunktierte Linie 40 jeweils als die linke Begrenzung der Halbleiterkörper aufgefasst werden. Dabei können die in die Schichten 2 und 3 Streifenform aufweisen und sich quer über die Grenzflächen 9 und 9a des Halbleiterkörpers oder über Teile davon erstrecken. Die längeren Abmessungen dieser Gebiete sind dann senkrecht zu den Zeichenebenen der Figuren 1 und 6 orientiert. In diesem Fall sind auch die Gates z. B. 14 und 15, die leitenden Belegungen, z. B. 16 und 17, die isolierenden Schichten, z. B. 12 und 13, und die Zündelektrode 20 mit Vorteil streifenförmig ausgebildet, wobei ihre längeren Abmessungen senkrecht zu den genannten Bildebenen liegen. Andererseits kann der Halbleiterkörper nach den Figuren 1 und 6 auch einen rotationssymmetrischen Aufbau mit der Linie 40 als Symmetrieachse aufweisen, wobei die einzelnen Schaltungsteile jeweils kreisringförmig ausgebildet sind.

Im Rahmen der Erfindung kann auch der p-Emitter 4 des Thyristors mit steuerbaren Stabilisierungs- und Löschkurzschlüssen versehen sein. Zur Erläuterung dieser Schaltungsvariante können die Figuren 1 und 6 herangezogen werden, wenn man die Bezeichnungen der Anschlüsse A und K miteinander vertauscht, die jeweils dargestellten Halbleitergebiete durch solche entgegengesetzter Leitfähigkeiten ersetzt und den Anschlüssen die genannten Spannungen und Ströme mit jeweils entgegengesetzten Polaritäten zuführt.

Die Zündelektrode 20 und die leitenden Belegungen 16 bzw. 16a können auch zu einer gemeinsamen Belegung zusammengefaßt sein, die mit dem Anschluß Z verbunden ist. Weiterhin kann auch die Belegung 16 bzw. 16a mit Z beschaltet sein, wobei dann die Zündelektrode 20 entfällt.

Die Eindringtiefe der n-Emittergebiete 1, 1a, 1b und 1c sowie der Kurzschlußgebiete, z. B. 7 und 8, in die p-Basisschicht 2 kann beispielsweise 3 μm betragen. Hierbei kommen dann für die Abstände der Kurzschlußgebiete, z. B. 7 und 8, von den zugeordneten n-Emittergebieten, z. B. 1, beispielsweise jeweils 5 μm in Betracht. Die lateralen Abmessungen der Kurzschlußgebiete 7, 8 in der Bildebene von Fig. 1 können z. B. jeweils 10 μm betragen. Die Dicke des Halbleiterkörpers des Thyristors nach den Figuren 1 oder 6 liegt z. B. in einem Bereich von 200 μm bis 1 mm.

**Patentansprüche**

1. Thyristor mit einem Halbleiterkörper, der einen von einer Kathode (K) kontaktierten n-Emitter (1) mit einer angrenzenden p-Basisschicht (2) und einen von einer Anode (A) kontaktierten p-Emitter (4) mit einer angrenzenden n-Basisschicht (3) aufweist, und mit an einer Grenzfläche des Halbleiterkörpers angeordneten, als MIS-Strukturen (M1, M2) ausgebildeten, steuerbaren Emitterkurzschlüssen, jeweils bestehend aus einem einen Randbereich des einen Emitters (1) bildenden, ersten Halbleitergebiet eines ersten Leitungstyps, das mit der diesen Emitter kontaktierenden Kathode (K) oder Anode (A) verbunden ist, einem mit der an diesen Emitter (1) angrenzenden Basisschicht (2) über eine leitende Belegung niederohmig verbundenen zweiten Halbleitergebiet, das aus einem in diese Basisschicht (2) eingefügten Kurzschlußgebiet (7, 8) gebildet ist, und einem zwischen diesen Halbleitergebieten liegenden Halbleiterbereich eines zweiten Leitungstyps, der aus einem bis an die den zuletzt genannten Emitter (1) enthaltende Grenzfläche des Halbleiterkörpers reichenden Teilbereich (10, 11) der an diesen Emitter (1) angrenzenden Basisschicht (2) besteht und von einem gegenüber dem Halbleiterkörper elektrisch isolierten Gate (14, 15) überdeckt ist,

dadurch gekennzeichnet, daß wenigstens eine dieser MIS-Strukturen dem Verarmungstyp und wenigstens eine der MIS-Strukturen dem Anreicherungstyp angehören, wobei ein erster gemeinsamer Steueranschluß (G1) für die Gates der MIS-Strukturen des einen Typs und ein zweiter, gemeinsamer Steueranschluß (G2) für die Gates der MIS-Strukturen des anderen Typs vorgesehen sind.

2. Thyristor mit einem Halbleiterkörper, der einen von einer Kathode (K) kontaktierten n-Emitter (1) mit einer angrenzenden p-Basisschicht (2) und einen von einer Anode (A) kontaktierten p-Emitter (4) mit einer angrenzenden n-Basisschicht (3) aufweist, und mit an einer Grenzfläche des Halbleiterkörpers angordneten, als MIS-Strukturen (M1, M2) ausgebildet, steuerbaren Emitterkurzschlüssen, jeweils bestehend aus einem einen Randbereich des einen Emitters (1) bildenden, ersten Halbleitergebiet eines ersten Leitungstyps, das mit der diesen Emitter kontaktierenden Kathode (K) oder Anode (A) verbunden ist, einem mit der an diesen Emitter (1) angrenzenden Basusschicht (2) über eine leitende Belegung niederohmig verbunden zweiten Halbleitergebiet, das aus einem in diese Basisschicht (2) eingefügten Kurzschlußgebiet (7, 8) gebildet ist, und einem zwischen diesen Halbleitergebieten liegenden Halbleiterbereich eines zweiten Leitungstyps, der aus einem bis an die den zuletzt genannten Emitter (1) enthaltende Grenzfläche des Halbleiterkörpers reichenden Teilbereich (10, 11) der an diesen Emitter (1) angrenzenden Basisschicht (2) besteht und von einem gegenüber dem Halbleiterkörper elektrisch isolierten Gate (14, 15) überdeckt ist,

dadurch gekennzeichnet, daß wenigstens zwei MIS-Strukturen vorgesehen sind, die einheitlich dem Verarmungstyp oder dem Anreicherungstyp angehören, wobei das Gate wenigstens einer der MIS-Strukturen mit einer Vorspannung beschaltet ist, die einen in dem überdeckten Halbleiterbereich bei spannungslosem Gate vorhandenden Halbleiterkanal beseitigt oder einen Halbleiterkanal aufbaut, und daß die mit der Vorspannung beschalteten Gates mit einem dritten gemeinsamen Steueranschluß und die Gates der übrigen MIS-Strukturen mit einem vierten gemeinsamen Steueranschluß verbunden sind.

3. Thyristor nach Anspruch 1 oder 2, dadurch gekennzeichnet, daß wenigstens eine MIS-Struktur (M1) dem Verarmungstyp angehört und ein in ihren überdeckten Halbleiterbereich (10) eingefügtes Kanalgebiet (18) des ersten Leitungstyps aufweist.

4. Thyristor nach einem der Ansprüche 1 bis 3, dadurch gekennzeichnet, daß die p-Basisschicht (2) mit einer Zündelektrode (20) versehen ist, die einen Anschluß (Z) für einen Zündstromkreis aufweist, und daß der Anschluß (Z) für den Zündstromkreis über eine Polaritätsumkehrschaltung (22), gegebenenfalls mit pegelverschiebender Funktion, mit dem ersten, zweiten, dritten oder vierten gemeinsamen Steuerspannungsanschluß (G1, G2) der MIS-Strukturen (M1, M2) verbunden ist.

5. Thyristor nach einem der Ansprüche 1 bis 4, dadurch gekennzeichnet, daß Kathode (6) und Anode (5) auf einander gegenüberliegenden Grenzflächen des Halbleiterkörpers angeordnet sind.

## Claims

1. A thyristor with a semiconductor body which has an n-emitter (1) which is contacted by a cathode (K) and is adjoined by a p-base layer (2), a p-emitter (4) which is contacted by an anode (A) and is adjoined by a n-base layer (3), and controllable emitter short-circuits which are arranged at a boundary surface of the semiconductor body and formed as MIS-structures (M1, M2), and consist in each case of a first semiconductor zone of a first conductivitv type which forms an edge zone of the first emitter (1) and is connected to the cathode (K) or anode (A) which contacts this emitter, a second semiconductor zone which is connected in low-ohmic fashion through a conductive coating to the base layer (2) which adjoins this emitter (1), and which consists of a short-circuit zone (7, 8) inserted in this base layer (2), and a semiconductor zone of a second conductivity type which is located between these two semiconductor zones and consists of a sub-zone (10, 11), of the base layer (2) which adjoins the emitter (1) extending to that boundary surface of the semiconductor body which contains the last-mentioned emitter (1), and which is covered by a gate (14, 15) which is electrically insulated from the semiconductor body, characterised in that at least one of these MIS-structures is of the depletion type and at least one of the MIS-structures is of the enhancement type, a first common control terminal (G1) being provided for the gates of the MIS-structures of the first type and a second, common control terminal (G2) being provided for the gates of the MIS-structures of the other type.

2. A thyristor with a semiconductor body which has an n-emitter (1) which is contacted by a cathode (K) and is adjoined by a p-base layer (2), and a p-emitter (4) which is contacted by an anode (A) and is adjoined by a n-base layer (3), and controllable emitter short-circuits which are arranged at a boundary surface of the semiconductor body and formed as MIS-structures (M1, M2), and consist in each case of a first semiconductor zone of a first conductivity type which forms an edge zone of the first emitter (1) and is connected to the cathode (K) or anode (A) which contacts this emitter, a second semiconductor zone which is connected in low-ohmic fashion through a conductive coating to the base layer (2) which adjoins this emitter (1), and which consists of a short-circuit zone (7, 8) inserted in this base zone (2), and a semiconductor zone of a second conductivity type which is located between these semiconductor zones and consist of a sub-zone (10, 11), of the base layer (2) which adjoins the emitter (1) extending to that boundary surface of the semiconductor body which contains the last-mentioned emitter (1), and which is covered by a gate (14, 15) which is electrically insulated from the semiconductor body, characterised in that at least two MIS-structures are provided which are uniformly of the depletion type, or of the enhancement type, the gate of at least on of the MIS-structures being connected to a bias voltage which eliminates a semiconductor channel is present in the covered semiconductor zone when the gate is floating, or which builds up a semiconductor channel; and that the gates connected to the bias voltage are connected to a third common control terminal and the gates of the other MIS-structures are connected to a fourth common control terminal.

3. A thyristor as claimed in Claim 1 or 2, characterised in that at least one MIS-structure (M1) is of the depletion type and contains a channel zone (18) of the first conductivity type which is inserted into its covered semiconductor zone (10).

4. A thyristor as claimed in one of claims 1 to 3, characterised in that the p-base zone (2) is provided with a firing electrode (20) which has a terminal (Z) for a firing circuit; and that the terminal (Z) for the firing circuit is connected through an inverter circuit (22), with a level-shifting function where appropriate, to the first, second, third or fourth common control voltage terminal (G1, G2) of the MIS-structure (M1, M2).

5. A thyristor as claimed in one of Claims 1 to 4, characterised in that cathode (6) and anode (5) are arranged on opposite boundary surfaces of the semiconductor body.

**Revendications**

1. Thyristor avec un corps semiconducteur pourvu d'un émetteur-n (1) en contact avec une cathode (K) et jouxtant une couche de base-p (2), avec un émetteur-p (4) en contact avec une anode (A) et jouxtant une couche de base-n voisine (3), avec des courts-circuits d'émetteur commandables disposés au niveau d'une surface limite du corps semiconducteur et réalisés sous la forme de structures MIS et dont chacune d'elles est constituée d'une première zone semiconductrice d'un premier typ de conductivité, constituant une zone marginale du premier émetteur-n (1) et reliée à la cathode (K) ou à l'anode (A) en contact avec cet émetteur, avec une seconde zone semiconductrice reliée par voie faiblement ohmique et par l'intermédiaire d'un revêtement conducteur, à la couche de base (2) jouxtant cet émetteur (1), ladite seconde zone semiconductrice étant formée par une zone de court-circuit (7, 8) insérée dans cette couche de base (2), et avec une zone semiconductrice d'un second type de conductivité, située entre ces zones semiconductrices, ladite zone semiconductrice dudit second type de conductivité étant constituée par une zone partielle (10, 11) de ladite couche de base (2) qui jouxte ledit émetteur (1), et qui s'étend jusqu'à la surface limite du corps semiconducteur, qui contient ledit émetteur (1), et qui est recouverte par une grille (14, 15) isolée électriquement par rapport au corps semiconducteur, caractérisé par le fait qu'au moins l'une de ces structures MIS appartient au type à appauvrissement et au moins l'une des structures MIS appartient au type à enrichissement, et que sont prévues une première borne commune de commande (G1) pour les grilles des structures MIS du premier type et une seconde borne commune de commande (G2) pour les structures MIS de l'autre type.

2. Thyristor avec un corps semiconducteur pourvu d'un émetteur-n (1) en contact avec une cathode (K) et jouxtant une couche de base-p (2), avec un émetteur-p (4) en contact avec une anode (A) et jouxtant une couche de base-n voisine (3), avec des courts-circuits d'émetteur commandables disposés au niveau d'une surface limite du corps semiconducteur et réalisés sous la forme de structures MIS et dont chacune d'elles est constituée d'une première zone semiconductrice d'un premier type de conductivité, constituant une zone marginale du premier émetteur-n (1) et reliée à la cathode (K) ou à l'anode (A) en contact avec cet émetteur, avec une seconde zone semiconductrice reliée par voie faiblement ohmique et par l'intermédiaire d'un revêtement conducteur, à la couche de base (2) jouxtant cet émetteur (1), ladite seconde zone semiconductrice étant formée par une zone de courts-circuits (7, 8) insérée dans cette couche de base (2), et avec une zone semiconductrice d'un second type de conductivité, située entre ces zones semiconductrices, ladite zone semiconductrice dudit second type de conductivité étant constituée par une zone partielle (10, 11), de ladite couche de base (2) qui jouxte ledit émetteur (1), et qui s'étend jusqu'à la surface limite du corps semiconducteur, qui contient ledit émetteur (1), et qui est recouverte par une grille (14, 15) isolée électriquement par rapport au corps semiconducteur, caractérisé par le fait que sont prévues au moins deux structures MIS qui appartiennent de façon homogène au type à appauvrissement ou au type à enrichissement, étant noté que la grille d'au moins l'une des structures MIS reçoit une tension de polarisation qui supprime un canal semiconducteur qui existe dans la zone semiconductrice recouverte, lorsqu'aucune tension n'est appliquée à la grille, ou qui établit un canal semiconducteur, et que les grilles qui reçoivent la tension de polarisation sont reliées à une troisième borne commune de commande, alors que les grilles des autres structures MIS sont reliées à une quatrième borne commune de commande.

3. Thyristor selon la revendication 1 ou 2, caractérisé par le fait qu'au moins une structure MIS (M1) appartient au type à appauvrissement et comporte une zone de canal (18) du premier type de conductivité, insérée dans la zone semiconductrice recouverte (10).

4. Thyristor selon l'une des revendications 1 à 3, caractérisé par le fait que la couche de base-p (2) est pourvue d'une électrode d'amorçage (20) qui comporte une borne (Z) pour un circuit d'amorçage, et que la borne (Z) pour le circuit d'amorçage est reliée, par l'intermédiaire d'un circuit d'inversion de polarité (22), éventuellement à fonction de déplacement du niveau, à la première, à la seconde, à la troisième ou à la quatrième borne commune de commande (G1, G2) des structures MIS (M1, M2).

5. Thyristor selon l'une des revendications 1 à 4, caractérisé par le fait que la cathode (6) et l'anode (5) sont disposées sur des surfaces limites du corps semiconducteur qui se situent l'une en face de l'autre.


## Revendications

1. Thyristor mit einem Halbleiterkörper, der einen von einer Kathode (K) kontaktierten n-Emitter (1) mit einer angrenzenden p-Basisschicht (2) und einen von einer Anode (A) kontaktierten p-Emitter (4) mit einer angrenzenden n-Basisschicht (3) aufweist, und mit an einer Grenzfläche des Halbleiterkörpers angeordneten, als MIS-Strukturen (MI, M2) ausgebildeten, steuerbaren Emitterkurzschlüssen, jeweils bestehend aus einem einen Randbereich des einen Emitters (1) bildenden, ersten Halbleitergebiet eines ersten Leitungstyps, das mit der diesen Emitter kontaktierenden Kathode (K) oder Anode (A) verbunden ist, einem mit der an diesen Emitter (1) angrenzenden Basisschicht (2) über eine leitende Belegung niederohmig verbundenen zweiten Halbleitergebiet, das aus einem in diese Basisschicht (2) eingefügten Kurzschlußgebiet (7, 8) gebildet ist, und einem zwischen diesen Halbleitergebieten liegenden Halbleiterbereich eines zweiten Leitungstyps, der aus einem bis an die den zuletzt genannten Emitter (1) enthaltende Grenzfläche des Halbleiterkörpers reichenden Teilbereich (10, 11) der an diesen Emitter (1) angrenzenden Basisschicht (2) besteht und von einem gegenüber dem Halbleiterkörper elektrisch isolierten Gate (14, 15) überdeckt ist, dadurch gekennzeichnet, daß wenigstens eine dieser MIS-Strukturen dem Verarmungstyp und wenigstens eine der MIS-Strukturen dem Anreicherungstyp angehören, wobei ein erster gemeinsamer Steueranschluß (GI) für die Gates der MIS-Strukturen des einen Typs und ein zweiter, gemeinsamer Steueranschluß (G2) für die Gates der MIS-Strukturen des anderen Typs vorgesehen sind.

2. Thyristor mit einem Halbleiterkörper, der einen von einer Kathode (K) kontaktierten n-Emitter (1) mit einer angrenzenden p-Basisschicht (2) und einen von einer Anode (A) kontaktierten p-Emitter (4) mit einer angrenzenden n-Basisschicht (3) aufweist, und mit an einer Grenzfläche des Halbleiterkörpers angordneten, als MIS-Strukturen (M1, M2) ausgebildet, steuerbaren Emitterkurzschlüssen, jeweils bestehend aus einem einen Randbereich des einen Emitters (1) bildenden, ersten Halbleitergebiet eines ersten Leitungstyps, das mit der diesen Emitter kontaktierenden Kathode (K) oder Anode (A) verbunden ist, einem mit der an diesen Emitter (1) angrenzenden Basusschicht (2) über eine leitende Belegung niederohmig verbunden zweiten Halbleitergebiet, das aus einem in diese Basisschicht (2) eingefügten Kurzschlugebiet (7, 8) gebildet ist, und einem zwischen diesen Halbleitergebieten liegenden Halbleiterbereich eines zweiten Leitungstyps, der aus einem bis an die den zuletzt genannten Emitter (1) enthaltende Grenzfläche des Halbleiterkörpers reichenden Teilbereich (10, 11) der an diesen Emitter (1) angrenzenden Basisschicht (2) besteht und von einem gegenüber dem Halbleiterkörper elektrisch isolierten Gate (14, 15) überdeckt ist, dadurch gekennzeichnet, da wenigstens zwei MIS-Strukturen vorgesehen sind, die einheitlich dem Verarmungstyp oder dem Anreicherungstyp angehören, wobei das Gate wenigstens einer der MIS-Strukturen mit einer Vorspannung beschaltet ist, die einen in dem überdeckten Halbleiterbereich bei spannungslosem Gate vorhandenden Halbleiterkanal beseitigt oder einen Halbleiterkanal aufbaut, und da die mit der Vorspannung beschalteten Gates mit einem dritten gemeinsamen Steueranschluß und die Gates der übrigen MIS-Strukturen mit einem vierten gemeinsamen Steueranschluß verbunden sind.

3. Thyristor nach Anspruch 1 oder 2, dadurch gekennzeichnet, da wenigstens eine MIS-Struktur (M1) dem Verarmungstyp angehört und ein in ihren überdeckten Halbleiterbereich (10) eingefügtes Kanalgebiet (18) des ersten Leitungstyps aufweist.

4. Thyristor nach einem der Ansprüche 1 bis 3, dadurch gekennzeichnet, da die p-Basisschicht (2) mit einer Zündelelektrode (20) versehen ist, die einen Anschluß (Z) für einen Zündstrom kreis aufweist, und daß der Anschluß (Z) für den Zündstromkreis über eine Polaritätsumkehrschaltung (22), gegebenenfalls mit pegelverechiebender Funktion, mit dem ereten, zweiten, dritten oder vierten gemeineamen Steuerspannungsanschluß (G1, G2) der MIS-Strukturen (M1, M2) verbunden ist.

5. Thyristor nach einem der Ansprüche 1 bis 4, dadurch gekennzeichnet, daß Kathode (6) und Anode (5) auf einander gegenüberliegenden Grenzflächen des Halbleiterkörpers angeordnet sind.

## Claims

1. A thyristor with a semiconductor body which has an n-emitter (I) which is contacted by a cathode (K) and is adjoined by a p-base layer (2), a p-emitter (4) which is contacted by an anode (A) and is adjoined by a n-base layer (3), and controllable emitter short-circuits which are arranged at a boundary surface of the semiconductor body and formed as MIB-structures (M1, M2), and consist in each case of a first semiconductor zone of a first conductivity type which forms an edge zone of the first emitter (I) and is connected to the cathode (K) or anode (A) which contacts this emitter, a second semiconductor zone which is connected in low-ohmic fashion through a conductive coating to the base layer (2) which adjoins this emitter (I), and which consists of a short-circuit zone (7, 8) inserted in this base layer (2), and a semiconductor zone of a second conductivity type which is located between these two semiconductor zones and consists of a sub-zone (10, II), of the base layer (2) which adjoins the emitter (I) extending to that boundary surface of the semiconductor body which contains the last-mentioned emitter (I), and which is covered by a gate (14, 15) which is electrically insulated from the semiconductor body, <u>characterised in</u> that at least one of these MIS-structures is of the depletion type and at least one of the MIS-structures is of the enhancement type, a first common control terminal (G1) being provided for the gates of the MIS-structures of the first type and a second, common control terminal (G2) being provided for the gates of the MIS-structures of the other type.

2. A thyristor with a semiconductor body which has an n-emitter (1) which is contacted by a cathode (K) and is adjoined by a p-base layer (2), and a p-emitter (4) which is contacted by an anode (A) and is adjoined by a n-base layer (3), and controllable emitter short-circuits which are arranged at a boundary surface of the semiconductor body and formed as MIS-structures (M1, M2), and consist in each case of a first semiconductor zone of a first conductivity type which forms an edge zone of the first emitter (I) and is connected to the cathode (K) or anode (A) which contacts this emitter, a second semiconductor zone which is connected in low-ohmic fashion through a conductive coating to the base layer (2) which adjoins this emitter (I), and which consists of a short-circuit zone (7, 8) inserted in this base zone (2), and a semiconductor zone of a second conductivity type which is located between these semiconductor zones and consist of a sub-zone (10, 11), of the base layer (2) which adjoins the emitter (1) extending to that boundary surface of the ssemiconductor body which contains the last-mentioned emitter (1), and which is covered by a gate (14, 15) which is electrically insulated from the semiconductor body, <u>characterised in</u> that at least two MIS-structures are provided which are uniformly of the depletion type, or of the enhacement type, the gate of at least on of the MIS-struktures being connected to a bias voltage which eliminates a semiconductor channel is present in the covered semiconductor zone when the gate is floating, or which builds up a semiconductor channel; and that the gates connected to the bias voltage are connected to a third common control terminal and the gates of the other MIS-structures are connected to a fourth common control terminal.

3. A thyristor as claimed in Claim 1 or 2, <u>characterised in</u> that at least one MIS-structure (M1) is of the depletion type and contains a channel zone (18) of the first conductivity type which is inserted into its covered semiconductor zone (10).

4. A thyristor as claimed in one of claims 1 to 3, <u>characterised in</u> that the p-base zone (2) is provided with a firing electrode (20) which has a terminal (Z) for a firing circuit; and that the terminal (Z) for the firing circuit is connected through an inverter circuit (22), with a level-shifting function where appropriate, to the first, second, third or fourth common control voltage terminal (G1, G2) of the MIS-structure (M1, M2).

5. A thyristor as claimed in one of Claims 1 to 4, <u>characterised in</u> that cathode (6) and anode (5) are arranged on opposite boundary surfaces of the semiconductor body.

## Revendications

1. Thyristor avec un corps semiconducteur pourvu d'un émetteur-n (1) en contact avec une cathode (K) et jouxtant une couche de base-p (2), avec un émetteur-p (4) en contact avec une anode (A) et jouxtant une couche de base-n voisine (3), avec des courts-circuits d'émetteur commandables disposés au niveau d'une surface limite du corps semiconducteur et réalisés sous la forme de structures MIS et dont chacune d'elles est constituée d'une première zone semiconductrice d'un premier typ de conductivité, constituant une zone marginale du premier émetteurn (1) et reliée à la cathode (K) ou à l'anode (A) en contact avec cet émetteur, avec une seconde zone semiconductrice reliée par voie faiblement ohmique et par l'intermédiaire d'un revétement conducteur, à la couche de base (2) jouxtant cet émetteur (1), ladite seconde zone semiconductrice étant formée par une zone de court-circuit (7, 8) insérée dans cette couche de base (2), et avec une zone semiconductrice d'un second type de conductivité, située entre ces zones semiconductrices, ladite zone semiconductrice dudit second type de conductivité étant constituée par une zone partielle (10, 11) de ladite couche de base (2) qui jouxte ledit émetteur (1), et qui s'étend jusqu'à la surface limite du corps semiconducteur, qui contient ledit émetteur (1), et qui est recouverte par une grille (14, 15) isolée électriquement par rapport au corps semiconducteur, caractérisé par le fait qu'au moins l'une de ces structures MIS appartient au type à appauvrissement et au moins l'une des structures MIS appartient au type à enrichissement, et que sont prévues une première borne commune de commande (G1) pour les grilles des structures MIS du premier type et une seconde borne commune de commande (G2) pour les structures MIS de l'autre type.

2. Thyristor avec un corps semiconducteur pourvu d'un émetteur-n (1) en contact avec une cathode (K) et jouxtant une couche de base-p (2), avec un émetteur-p (4) en contact avec une anode (A) et jouxtant une couche de base-n voisine (3), avec des courts-circuits d'émetteur commandables disposés au niveau d'une surface limite du corps semiconducteur et réalisés sous la forme de structures MIS et dont chacune d'elles est constituée d'une première zone semiconductrice d'un premier type de conductivité, constituant une zone marginale du premier émetteur n (1) et reliée à la cathode (K) ou à l'anode (A) en contact avec cet émetteur, avec une seconde zone semiconductrice reliée par voie faiblement ohmique et par l'intermédiaire d'un revétement conducteur, à la couche de base (2) jouxtant cet émetteur (1), ladite seconde zone semiconductrice étant formée par une zone de courts-circuits (7, 8) insérée dans cette couche de base (2), et avec une zone semiconductrice d'un second type de conductivité, située entre ces zones semiconductrices, ladite zone semiconductrice dudit second type de conductivité étant constituée par une zone partielle (10, 11), de ladite couche de base (2) qui jouxte ledit émetteur (1), et qui s'étend jusqu'à la surface limite du corps semiconducteur, qui contient ledit émetteur (1), et qui est recouverte par une grille (14, 15) isolée électriquement par rapport au corps semiconducteur, caractérisé par le fait que sont prévues au moins deux structures MIS qui appartiennent de façon homogène au type à appauvrissement ou au type à enrichissement, étant noté que la grille d'au moins l'une des structures MIS reçoit une tension de polarisation qui supprime un canal semiconducteur qui existe dans la zone semiconductrice recouverte, lorsqu'aucune tension n'est appliquée à la grille, ou qui établit un canal semiconducteur, et que les grilles qui reçoivent la tension de polarisation sont reliées à une troisième borne commune de commande, alors que les grilles des autres structures MIS sont reliées à une quatrième borne commune de commande.

3. Thyristor selon la revendication 1 ou 2, caractérisé par le fait qu'au moins une structure MIS (MI) appartient au type à appauvrissement et comporte une zone de canal (18) du premier type de conductivité, insérée dans la zone semiconductrice recouverte (10).

4. Thyristor selon l'une des revendications 1 à 3, caractérisé par le fait que la couche de base p (2) est pourvue d'une électrode d'amorçage (20) qui comporte une borne (Z) pour un circuit d'amorçage, et que la borne (Z) pour le circuit d'amorçage est reliée, par l'intermédiaire d'un circuit d'inversion de polarité (22), éventuellement à fonction de déplacement du niveau, à la première, à la seconde, à la troisième ou à la quatrième borne commune de commande (G1, G2) des structures MIS (M1, M2).

5. Thyristor selon l'une des revendications 1 à 4, caractérisé par le fait que la cathode (6) et l'anode (5) sont disposées sur des surfaces limites du corps semiconducteur qui se situent l'une en face de l'autre.

FIG 1

FIG 6

0 065 173

1

FIG 2a

FIG 3a

FIG 2b

FIG 3b

FIG 4

FIG 5